# EUROPEAN PATENT APPLICATION

(11) **EP 4 827 293 A1**
(43) Date of publication of application: **21.10.2026**
(21) Application number: 26168008.6
(22) Date of filing: 26.03.2026
(51) Int. Cl.: H10K 59/122, H10K 59/35, H10K 59/38, H10K 59/80

(54) **DISPLAY DEVICE AND ELECTRONIC DEVICE HAVING THE SAME**

(30) Priority: 15.04.2025 KR 20250049022
(71) Applicant: Samsung Display Co., Ltd., Yongin-si, Gyeonggi-do 17113 (KR)
(72) Inventor: KIM, Gee-Bum, 17113 Yongin-si (KR); KIM, Hyunho, 17113 Yongin-si (KR); CHO, Wonseok, 17113 Yongin-si (KR)
(74) Representative: Walaski, Jan Filip

(57) **Abstract**

A display device includes a substrate including a front display area and a side display area having a preset curvature, a pixel definition layer on the substrate, and an optical functional layer on the pixel definition layer, wherein the front display area includes a central display area and a side-adjacent display area between the central display area and the side display area. The pixel definition layer includes a first-1 opening overlapping the central display area, a first-2 opening overlapping the side-adjacent display area, and a first-3 opening overlapping the side display area. The optical functional layer includes a second-1 opening overlapping the first-1 opening, a second-2 opening overlapping the first-2 opening, and a second-3 opening overlapping the first-3 opening, and the first-2 opening is positioned, along the first direction, offset relative to one side of the second-2 opening in the first direction.

## Description

### BACKGROUND

### 1. Field

The disclosure relates to a display device and an electronic device including the display device, and for example, to a display device with improved display quality and an electronic device including the display device.

### 2. Description of the Related Art

Display devices are devices that include a display screen, and include, for example, liquid crystal displays (LCDs) and organic light-emitting diodes (OLEDs). These display devices are used in various electronic devices, such as mobile phones, navigation devices, digital cameras, e-books, portable game consoles, and various types of terminals.

A display device may include a display panel for displaying an image and a cover window for protecting the display panel. The display device may be curved, *e.g*., may have one or various curvatures. The display panel may include a plurality of pixels that emit light of different colors. In such cases, when light having a first color emitted from one of the plurality of pixels is mixed with light having a second color different from the first color emitted from another pixel of the plurality of pixels, the display quality of the display device may deteriorate and user fatigue associated with the use of the display device may increase.

The above information disclosed in this Background section is intended to enhance understanding of the background of the disclosure and may contain information that does not constitute prior art.

### SUMMARY

Aspects of embodiments are directed to providing a display device with improved display quality and to an electronic device including the display device.

However, these aspects are merely examples, and the scope of the present disclosure is not limited thereby.

Additional aspects will be set forth in part in the description which follows and, in part, will be apparent from the description, or may be learned by practice of the presented embodiments of the disclosure.

According to one or more embodiments, a display device includes a substrate including a front display area and a side display area connected to the front display area in a first direction and having a preset curvature, a pixel definition layer positioned on (above) the substrate, and an optical functional layer positioned on the pixel definition layer, wherein the front display area includes a central display area and a side-adjacent display area positioned between the central display area and the side display area, the pixel definition layer includes a first-1 opening overlapping the central display area, a first-2 opening overlapping the side-adjacent display area, and a first-3 opening overlapping the side display area, and the optical functional layer includes a second-1 opening overlapping the first-1 opening, a second-2 opening overlapping the first-2 opening, and a second-3 opening overlapping the first-3 opening, wherein the first-2 opening is positioned, along the first direction, offset relative to one side of the second-2 opening in the first direction.

In one or more embodiments, the width of the second-1 opening, the width of the second-2 opening, and the width of the second-3 opening may be different from each other.

In one or more embodiments, the width of the first-1 opening, the width of the first-2 opening, and the width of the first-3 opening may be the same.

In one or more embodiments, the width of the second-2 opening may be larger (greater) than the width of the first-2 opening, and the width of the second-3 opening may be equal to the width of the first-3 opening.

In one or more embodiments, the width of the second-2 opening may be smaller than the width of the second-1 opening and larger (greater) than the width of the second-3 opening.

In one or more embodiments, the center of the first-1 opening may overlap the center of the second-1 opening, and the center of the first-3 opening may overlap the center of the second-3 opening.

In one or more embodiments, a first distance between one end of the first-1 opening and one end of the second-1 opening may be equal to a second distance between one end of the first-2 opening and one end of the second-2 opening.

In one or more embodiments, the first-3 opening may be positioned, along the first direction, offset relative to one side of the second-3 opening in the direction of the front display area.

In one or more embodiments, a separation distance between the first-1 opening and the first-2 opening may be the same as a separation distance between the first-2 opening and the first-3 opening.

In one or more embodiments, a separation distance between the first-1 opening and the first-2 opening may be greater than a separation distance between the first-2 opening and the first-3 opening.

According to one or more embodiments, a display device includes a substrate having a front display area and a side display area connected to the front display area in a first direction and having a preset curvature, a pixel definition layer positioned on (above) the substrate, and an optical functional layer positioned on the pixel definition layer, wherein the front display area includes a central display area and a side-adjacent display area positioned between the central display area and the side display area, the pixel definition layer includes a first-1 opening overlapping the central display area, a first-2 opening overlapping the side-adjacent display area, and a first-3 opening overlapping the side display area, and the optical functional layer includes a second-1 opening overlapping the first-1 opening, a second-2 opening overlapping the first-2 opening, and a second-3 opening overlapping the first-3 opening, wherein a ratio of the width of the first-1 opening to the width of the second-1 opening, a ratio of the width of the first-2 opening to the width of the second-2 opening, and a ratio of the width of the first-3 opening to the width of the second-3 opening are different from one another.

In one or more embodiments, the width of the first-1 opening, the width of the first-2 opening, and the width of the first-3 opening may be the same, and the width of the second-1 opening, the width of the second-2 opening, and the width of the second-3 opening may be different from each other.

In one or more embodiments, the width of the second-2 opening may be smaller than the width of the second-1 opening and larger (greater) than the width of the second-3 opening.

In one or more embodiments, the width of the second-2 opening may be larger (greater) than the width of the first-2 opening, and the width of the second-3 opening may be the same as the width of the first-3 opening.

In one or more embodiments, the first-2 opening may be positioned, along the first direction, offset relative to one side of the second-2 opening.

In one or more embodiments, the center of the first-1 opening may coincide with the center of the second-1 opening, and the center of the first-3 opening may coincide with the center of the second-3 opening.

In one or more embodiments, a first distance between one end of the first-1 opening and one end of the second-1 opening may be equal to a second distance between one end of the first-2 opening and one end of the second-2 opening.

In one or more embodiments, the first-3 opening may be positioned, along the first direction, offset relative to the second-3 opening in the direction of the front display area.

In one or more embodiments, a separation distance between the first-1 opening and the first-2 opening may be the same as a separation distance between the first-2 opening and the first-3 opening.

According to one or more embodiments, an electronic device includes a processor which generates (e.g., is configured to generate) a scan input signal, a power module which generates (e.g., is configured to generate) a scan input voltage, and a display device which receives (e.g., is configured to receive) the scan input signal and the scan input voltage and outputs (e.g., is configured to output) a scan signal to a pixel circuit, wherein the display device includes a substrate which includes a front display area and a side display area which is connected to the front display area in a first direction and has a preset curvature, a pixel definition layer which is positioned on (above) the substrate, and an optical functional layer positioned on the pixel definition layer, wherein the front display area includes a central display area and a side-adjacent display area positioned between the central display area and the side display area, the pixel definition layer includes a first-1 opening overlapping the central display area a first-2 opening overlapping the side-adjacent display area, and a first-3 opening overlapping the side display area, and the optical functional layer includes a second-1 opening overlapping the first-1 opening, a second-2 opening overlapping the first-2 opening, and a second-3 opening overlapping the first-3 opening, and the first-2 opening is positioned, along the first direction, offset relative to one side of the second-2 opening in the first direction.

Other aspects, features, principles and/or advantages other than those described above will become apparent from the following drawings, claims and detailed description of the disclosure.

### BRIEF DESCRIPTION OF THE DRAWINGS

The accompanying drawings are included to provide a further understanding of the present disclosure, and are incorporated in and constitute a part of this specification. The drawings illustrate example embodiments and, together with the description, serve to explain principles of the present disclosure. In the drawings:
FIG. 1 is a perspective view of a display device according to one or more embodiments;
FIG. 2 is a cross-sectional view taken along the line I-I' of FIG. 1, according to one or more embodiments;
FIG. 3 is an equivalent circuit diagram of one pixel included in a display device according to one or more embodiments;
FIG. 4 is a cross-sectional view taken along the line II-II' of FIG. 1, according to one or more embodiments;
FIG. 5 is an enlarged cross-sectional view of the portion AA of FIG. 4, according to one or more embodiments;
FIG. 6 is an enlarged cross-sectional view of the first pixel portion of FIG. 5, according to one or more embodiments;
FIG. 7 is an enlarged cross-sectional view of the second pixel portion of FIG. 5, according to one or more embodiments;
FIG. 8 is an enlarged cross-sectional view of the third pixel portion of FIG. 5, according to one or more embodiments;
FIG. 9 is a cross-sectional view of the portion AA of FIG. 4, according to one or more embodiments;
FIG. 10 is a cross-sectional view of the portion AA of FIG. 4, according to one or more embodiments;
FIG. 11 is a block diagram of an electronic device according to one or more embodiments; and
FIG. 12 is a schematic diagram of electronic devices according to various embodiments.

### DETAILED DESCRIPTION

The present disclosure may be modified in many alternate forms, and thus specific embodiments will be illustrated in the drawings and described in more detail. It should be understood, however, that this is not intended to limit the present disclosure to the particular forms disclosed, but rather, is intended to cover all modifications, equivalents, and alternatives falling within the scope of the present disclosure.

Hereinafter, example embodiments will be described in more detail with reference to the accompanying drawings. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art. Accordingly, processes, elements, and techniques that are not necessary to those having ordinary skill in the art for a complete understanding of the aspects and features of the present disclosure may not be described.

Hereinafter, embodiments will be described in more detail with reference to the attached drawings. When describing with reference to the drawings, substantially identical or corresponding components may be given the same drawing reference numerals and redundant descriptions thereof are omitted. Unless otherwise noted, like reference numerals denote like elements throughout the attached drawings and the written description, and thus, duplicative descriptions thereof may not be provided.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure.

As used herein, the singular forms "a," "an" and "the" are intended to include the plural forms as well, unless the context clearly indicates otherwise.

It will be further understood that the terms "comprises," "comprising," "includes," "including," "have," and "having," when used in this specification, specify the presence of the stated features, integers, steps, operations, elements, and/or components, but do not preclude the presence or addition of one or more other features, integers, steps, operations, elements, components, and/or groups thereof. Additionally, the terms "comprise(s)/comprising," "include(s)/including," "have/has/having" or similar terms include or support the terms "consisting of" and "consisting essentially of," indicating the presence of stated features, integers, steps, operations, elements, and/or components, without or essentially without the presence of other features, integers, steps, operations, elements, components, and/or groups thereof.

It will be understood that when an element, such as an area, layer, film, region or portion, is referred to as being "on," "connected to," or "over" another element, it can be directly on, connected, or over to the other element, or one or more intervening elements may be present. In contrast, when an element or layer is referred to as being "directly on," "directly connected to", "directly over" or "immediately adjacent to" another element or layer, there are no intervening elements or layers present. In addition, it will also be understood that when an element is referred to as being "between" two elements, it can be the only element between the two elements, or one or more intervening elements may also be present.

In the drawings, the sizes of components may be exaggerated or reduced for convenience of explanation. For example, the relative sizes (e.g., including lengths, widths and thicknesses) of elements, layers, regions, *etc.* shown in the drawing may be illustrated for convenience of explanation, and thus the present disclosure is not necessarily limited to what is illustrated.

In cases where one or more embodiments may be implemented in a different manner, specific process sequences may be performed in an order different from that described. For example, two processes described sequentially may be performed substantially concurrently (e.g., simultaneously), or may proceed in the reverse order from that described.

In this specification, "A and/or B" refers to either A, B, or both A and B. In addition, the expression "at least one of A and B" refers to A alone, B alone, or both A and B together.

In this specification in case where a film, region, component, etc. are described as being electrically connected, it refers to a case where the film, region, component, *etc.* are directly electrically connected, and/or a case where another film, region, component, *etc.* is interposed between them and is indirectly electrically connected.

The x-axis, y-axis, and z-axis are not limited to the three axes on the orthogonal coordinate system, and may be interpreted in a broader sense to include them. For example, the x-axis, y-axis, and z-axis may be orthogonal to each other, but they may also refer to different directions that are not orthogonal to each other.

Spatially relative terms, such as "on," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the drawings. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.

As used herein, the term "and/or" includes any and all combinations of one or more of the associated listed items. Unless otherwise apparent from the disclosure, expressions such as "at least one of," "a plurality of," "one of," and other prepositional phrases, when preceding a list of elements, should be understood as including the disjunctive if written as a conjunctive list and vice versa. For example, the expressions "at least one of a, b, or c," "at least one of a, b, and/or c," "one selected from the group consisting of a, b, and c," "at least one selected from among a, b, and c," "at least one from among a, b, and c," "one from among a, b, and c", "at least one of a to c" indicates only a, only b, only c, both a and b, both a and c, both b and c, all of a, b, and c, or variations thereof.

As used herein, the terms "use," "using," and "used" may be considered synonymous with the terms "utilize," "utilizing," and "utilized," respectively.

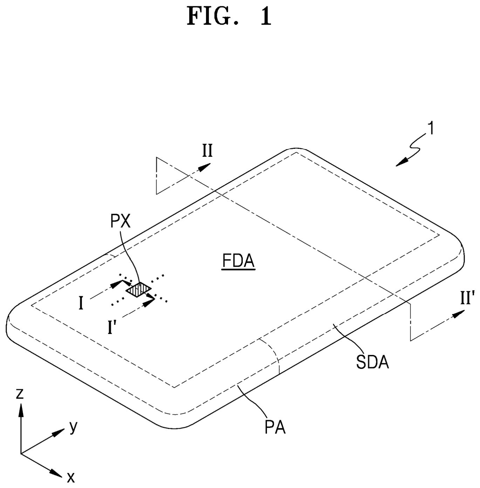

FIG. 1 is a perspective view schematically illustrating a display device 1 according to one or more embodiments.

Referring to FIG. 1, the display device 1 may have, for example, a rectangular shape on a plane (e.g., in a plan view). In some embodiments, the display device 1 may have one or more suitable shapes, such as a polygonal shape including a triangular or quadrilateral shape, or a circular or elliptical shape. In one or more embodiments, where the display device 1 has a polygonal shape in a plan view, the corners of the polygon may be rounded. For convenience of explanation, the following explanation will focus on the case where the display device 1 has a rectangular shape with rounded corners in a plan view.

In one or more embodiments, the display device 1 may have a short side in a first direction *(e.g.,* the x-direction) and a long side in a second direction *(e.g.,* the y-direction). In this regard, the first direction and the second direction may be intersecting directions. The present disclosure is not limited thereto, and in one or more embodiments, the display device 1 may have a short side in the first direction and a long side in the second direction, or the side in the first direction and the side in the second direction may have the same length.

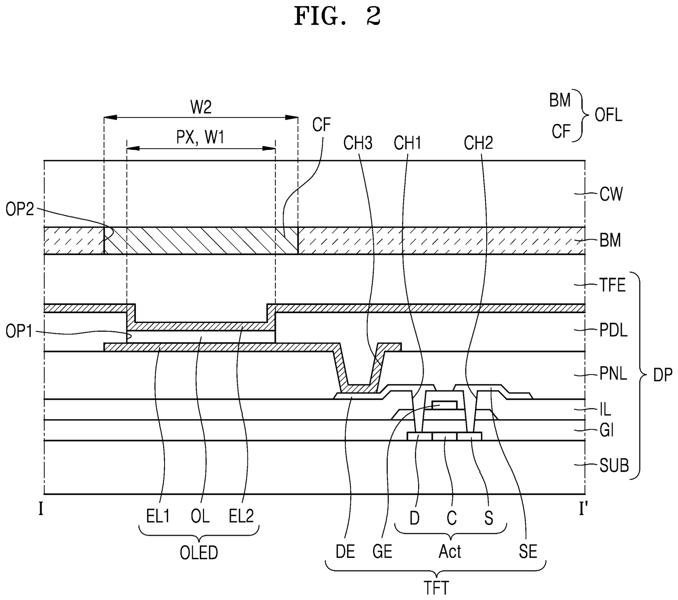

The display device 1 may include a display area DA for displaying an image and a peripheral area PA around (e.g., surrounding) the display area DA. This may be understood as meaning that the display panel *(e.g.,* the display panel DP, *see, e.g.,* FIG. 2) or substrate *(e.g.,* the substrate SUB, *see, e.g.,* FIG. 2) included in the display device 1 has such a display area DA and a peripheral area PA. The display area DA may generally occupy the center of the display device 1.

The display area DA may include multiple pixels PX. The multiple pixels PX may be arranged in a matrix. The shape of each pixel PX may be a rectangle or a square on a plane (e.g., in a plan view), but the present disclosure is not limited thereto, and each pixel PX may also have a rhombic shape in which each side is inclined in one direction. The pixels PX may be arranged in the form of a Pentile^{®} (for example, an RGBG matrix, an RGBG structure, or RGBG matrix structure) or alternatively arranged in a stripe shape. PENTILE^{®} is a duly registered trademark of Samsung Display Co., Ltd.

A pixel PX may be defined as a region where light is emitted by light-emitting elements provided in a display device 1. Therefore, the display area DA may be defined by a plurality of light-emitting elements. Each pixel PX represents a sub-pixel and may include a light-emitting element such as an organic light-emitting diode OLED and a pixel circuit connected thereto. Each pixel PX may emit light of a specific wavelength and display a specific color. For example, each pixel PX may emit red, green, blue, or white light. The display device 1 may provide an image using light emitted from arranged pixels PX.

The display area DA may include a front display area FDA and a side display area SDA. In one or more embodiments, the pixels PXs of the front display area FDA and the side display area SDA may each provide independent images. In one or more embodiments, the pixels PX of the front display area FDA and the side display area SDA may each provide portions of a single image.

The front display area FDA may include a flat surface and, for example, may have a rectangular shape on a plane (e.g., in a plan view). The front display area FDA may occupy the largest proportion of the display area DA of the display device 1 and thus may provide most of the image.

The side display area SDA may extend outward from each edge of the front display area FDA. For example, the side display area SDA may include a first side display area extending from a first edge of the front display area FDA, a second side display area extending from a second edge, a third side display area extending from a third edge, and a fourth side display area extending from a fourth edge. At least one of the first to fourth side display areas may not be provided.

The side display area SDA may include a curved surface having a preset curvature. For example, a first side display area extending in a first direction (e.g., in the x direction) from an edge of the front display area FDA may have a curved surface bent about a bending axis extending in a second direction *(e.g.,* in the y direction) intersecting the first direction. The curvatures of the first to the fourth side display areas may be the same or different from each other.

The display device 1 may display an image not only in the front display area FDA but also in the side display area SDA. Accordingly, the proportion of the display area DA occupying the display device 1 may be increased. For example, in a display device 1 of the same size, the area of the peripheral area PA may be reduced and the area of the display area DA may be increased.

The peripheral area PA may be a non-display area that does not provide an image, and pixels PX may not be positioned in the peripheral area PA. The peripheral area PA may fully or partially be around (e.g., surround) the display area DA. The peripheral area PA may constitute the bezel of the display device 1. Drivers, and/or the like for providing electrical signals or power to the display area DA may be positioned in the peripheral area PA.

FIG. 2 is a cross-sectional view schematically illustrating a part of a display device 1 according to one or more embodiments. FIG. 2 may correspond to a cross-section taken along the line I-I' of the display device 1 of FIG. 1, according to one or more embodiments.

Referring to FIG. 2, the display device 1 may include a display panel DP, an optical functional layer OFL, and a cover window CW. the display panel DP may be an inorganic light-emitting diode display panel, an organic light-emitting display panel, a quantum dot light-emitting display panel, a plasma display panel, or a field emission display panel. Hereinafter, an organic light-emitting display panel is illustrated as the display panel (DP); however, the present disclosure is not limited thereto, and in case that the same technical idea is applicable, it may also be applied to other types (kinds) of display panels.

The display panel DP may include a stacked structure of a substrate SUB, a pixel circuit layer, a display layer, and an encapsulation layer TFE. The pixel circuit layer may include a thin-film transistor TFT, and the display layer may include an organic light-emitting diode OLED.

The substrate SUB may be made of any generally available and/or generally utilized material in the art. The substrate SUB may be a flexible substrate. The substrate SUB may be a plastic substrate using glass or polymer resin. For example, the substrate SUB may include polyethylene terephthalate (PET), polyethylene naphthalate (PEN), polyimide, polyether sulfone, and/or the like. The substrate SUB may have a multilayer structure including a base layer containing a polymer resin and an inorganic layer. The substrate SUB may be selected by considering mechanical strength, thermal stability, transparency, surface smoothness, ease of handling, waterproofing, and/or the like. The substrate SUB may be transparent, but the present disclosure is not limited thereto.

A buffer layer may be positioned above the substrate SUB. The buffer layer may reduce or block the penetration of foreign substances, moisture or external air from the lower portion of the substrate SUB and may provide a flat surface on the substrate SUB. The buffer layer may include silicon nitride (SiNₓ), silicon oxide (SiOₓ), silicon nitride oxide (SiOₓN_{y}), and/or the like, and may not be provided depending on the material of the substrate SUB and process conditions.

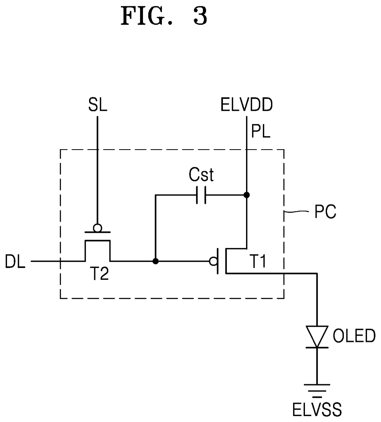

A pixel circuit layer may be positioned above the substrate SUB. The pixel circuit layer may include a pixel circuit *(e.g.,* pixel circuit PC, *see, e.g.,* FIG. 3) including a thin-film transistor TFT and a storage capacitor *(e.g.,* storage capacitor Cst, *see, e.g.,* FIG. 3). In one or more embodiments, the pixel circuit layer may include an insulating layer positioned below and/or above the components of the pixel circuit PC.

A thin-film transistor TFT may include a semiconductor layer Act, a gate electrode GE, a drain electrode DE, and a source electrode SE. The semiconductor layer Act may include, for example, polysilicon or amorphous silicon, or may include an oxide semiconductor, an organic semiconductor, and/or the like. The semiconductor layer Act may include a channel region C, and a drain region D and a source region S respectively arranged on both sides (e.g., opposite sides) of the channel region C.

The gate electrode GE may overlap the channel region C. The gate electrode GE may include a low-resistance metal material. For example, the gate electrode GE may include a conductive material containing molybdenum (Mo), aluminum (Al), copper (Cu), titanium (Ti), and/or the like, and may be formed as a single layer or a multilayer including these materials.

A gate insulating layer GI may be positioned between the semiconductor layer Act and the gate electrode GE. For example, the gate insulating layer GI may include an inorganic insulating material such as silicon oxide (SiO₂), silicon nitride (SiNₓ), silicon oxynitride (SiOₓN_{y}), aluminum oxide (Al₂O₃), titanium oxide (TiO₂), tantalum oxide (Ta₂O₅), hafnium oxide (HfO₂), and/or zinc oxide (ZnO₂).

An interlayer insulating layer IL may be positioned on the gate electrode GE. An interlayer insulating layer IL may cover a gate electrode GE. For example, the interlayer insulating layer IL may include an inorganic insulating material such as silicon oxide (SiO₂), silicon nitride (SiNₓ), silicon oxynitride (SiOₓN_{y}), aluminum oxide (Al₂O₃), titanium oxide (TiO₂), tantalum oxide (Ta₂O₅), hafnium oxide (HfO₂), and/or zinc oxide (ZnO₂). The interlayer insulating layer IL may be a single layer or a plurality of layers including the materials described above.

A drain electrode DE and a source electrode SE may be arranged on the interlayer insulating layer IL. The drain electrode DE may be connected to the drain region D through a first contact hole CH1 formed in the gate insulating layer GI and the interlayer insulating layer IL, and the source electrode SE may be connected to the source region S through a second contact hole CH2 formed in the gate insulating layer GI and the interlayer insulating layer IL. For example, the drain electrode DE and the source electrode SE may include a conductive material containing molybdenum (Mo), aluminum (Al), copper (Cu), titanium (Ti), and/or the like.

A planarizing insulating layer PNL may cover the drain electrode DE and the source electrode SE. The planarizing insulating layer PNL may act as a planarization film that planarizes the upper surface on which the thin-film transistor TFT is positioned, and may also act as a protective film that protects the thin-film transistor TFT. For example, the planarizing insulating layer PNL may include an organic insulator such as a general-purpose polymer such as polymethyl methacrylate (PMMA) or polystyrene (PS), a polymer derivative having a phenol group, an acrylic polymer, an imide polymer, an aryl ether polymer, an amide polymer, a fluorinated polymer, a p-xylene polymer, a vinyl alcohol polymer, and/or a blend thereof.

A display layer may be positioned on the pixel circuit layer of the structure. The display layer may include an organic light-emitting diode OLED as a light-emitting element. An organic light-emitting diode OLED may include a first electrode EL1, an intermediate layer OL, and a second electrode EL2 that are sequentially stacked. Organic light-emitting diodes OLEDs may emit red, green, blue, or white light, for example. Organic light-emitting diodes OLEDs emit light through their emission regions, which may be defined as pixels PX.

The first electrode EL1 may be positioned on a planarizing insulating layer PNL. The first electrode EL1 may include a conductive material and may be electrically connected to a thin-film transistor TFT. For example, the first electrode EL1 may be connected to the drain electrode DE of the thin-film transistor TFT through a third contact hole CH3 formed in the planarizing insulating layer PNL. The first electrode EL1 may be an anode or a pixel electrode.

In one or more embodiments, the first electrode EL1 may be, but is not limited to, a reflective electrode. As another example, the first electrode EL1 may be a transmissive electrode or a semi-transmissive electrode. In embodiments in which the first electrode EL1 is a semi-transmissive electrode or a reflective electrode, the first electrode EL1 may include Ag, Mg, Cu, Al, Pt, Pd, Au, Ni, Nd, Ir, Cr, Li, Ca, LiF/Ca, LiF/Al, Mo, Ti, or a *(e.g.,* any suitable) compound or mixture thereof (e.g., a mixture of Ag and Mg). In one or more embodiments, it may be a multi-layer structure including a reflective film or a semi-transparent film formed of the materials exemplified above and a transparent conductive film formed of indium tin oxide (ITO), indium zinc oxide (IZO), zinc oxide (ZnO), indium tin zinc oxide (ITZO), and/or the like.

A pixel definition layer PDL may be positioned on the first electrode EL1. A first opening OP1 exposing the central portion of the first electrode EL1 may be formed in the pixel definition layer PDL. The first opening OP1 may define the light-emitting area of light emitted from the organic light-emitting diode OLED. For example, the size and/or the width of the first opening OP1 may correspond to the size and/or the width of the light-emitting area. Therefore, the size and/or the width of a pixel PX may depend on the size and/or the width of the first opening OP1 of the corresponding pixel definition layer PDL.

The pixel definition layer PDL may include an organic insulator and/or an inorganic insulator. In one or more embodiments, the pixel definition layer includes a polymer resin. For example, the pixel definition layer PDL may include a polyacrylate-based resin or a polyimide-based resin. In one or more embodiments, the pixel definition layer PDL may be formed by including an inorganic material in addition to a polymer resin. In one or more embodiments, the pixel definition layer PDL may be formed by including a light absorbing material, or by including a black pigment and/or a black dye. A pixel definition layer PDL formed by including a black pigment and/or a black dye may implement a black pixel definition layer. Carbon black and/or the like may be used as a black pigment and/or a black dye when forming a pixel definition layer PDL, but the present disclosure is not limited thereto.

An intermediate layer OL may be positioned on the first electrode EL1. The intermediate layer OL may be positioned within the first opening OP1. The intermediate layer OL may include a light-emitting layer formed to correspond to the first electrode EL1. The light-emitting layer may include a polymer or low-molecular-weight organic material that emits light of a preset color. In one or more embodiments, the light-emitting layer may include an inorganic light-emitting material or may include quantum dots.

A first functional layer and a second functional layer may be arranged below and above the light-emitting layer, respectively. The first functional layer may include, for example, a hole transport layer (HTL) or a hole transport layer and a hole injection layer (HIL). The second functional layer is a component positioned on the light-emitting layer and may include an electron transport layer (ETL) and/or an electron injection layer (EIL).

The second electrode EL2 is positioned on the intermediate layer OL and may overlap the first electrode EL1. The second electrode EL2 may be a common electrode or a cathode. The second electrode EL2 may be formed integrally to cover the entire substrate SUB. The second electrode EL2 may include a conductive material having a low work function. The second electrode EL2 may be a transmissive electrode, a semi-transmissive electrode, or a reflective electrode. In embodiments in which the second electrode EL2 is a transmissive electrode, the second electrode EL2 may include a transparent metal oxide, such as indium tin oxide (ITO), indium zinc oxide (IZO), zinc oxide (ZnO), and/or indium tin zinc oxide (ITZO).

In embodiments in which the second electrode EL2 is a semi-transmissive electrode or a reflective electrode, the second electrode EL2 may include Ag, Mg, Cu, Al, Pt, Pd, Au, Ni, Nd, Ir, Cr, Li, Ca, LiF/Ca, LiF/Al, Mo, Ti, or a *(e.g.,* any suitable) compound and/or a mixture thereof (e.g., a mixture of Ag and Mg). In one or more embodiments, the electrode may be a multi-layer structure including a reflective film or a semi-transmissive film formed of the materials described above, and a transparent conductive film formed of indium tin oxide (ITO), indium zinc oxide (IZO), zinc oxide (ZnO), indium tin zinc oxide (ITZO), and/or the like.

In one or more embodiments, the first electrode EL1 and the second electrode EL2 may face each other, where the first electrode EL1 may be a reflective electrode and the second electrode EL2 may be a transmissive electrode, but the present disclosure is not limited thereto.

An encapsulation layer TFE may be positioned on the second electrode EL2. The encapsulation layer TFE may be positioned to cover the second electrode EL2. The encapsulation layer TFE may include at least one of an organic layer and/or an inorganic layer. For example, the encapsulation layer TFE may be formed to include at least one organic layer and at least one inorganic layer. The inorganic layer may include an inorganic insulator such as silicon oxide (SiO₂), silicon nitride (SiNₓ), silicon oxynitride (SiOₓN_{y}), aluminum oxide (Al₂O₃), titanium oxide (TiO₂), tantalum oxide (Ta₂O₅), hafnium oxide (HfO₂), and/or zinc oxide (ZnO₂). The organic layer may include an organic insulating material such as an acrylic resin, an epoxy resin, polyimide, and/or polyethylene.

The encapsulation layer TFE may protect the organic light-emitting diode OLED. The encapsulation layer TFE may cover the upper surface of the second electrode EL2 positioned in the first opening OP1 and may fill the first opening OP1. The encapsulation layer TFE may be positioned on an organic light-emitting diode OLED to function as a planarization film.

The optical functional layer OFL may be positioned on the encapsulation layer TFE. The optical functional layer OFL can reduce the reflectivity of external light incident from the outside toward the display device 1 and/or improve the color purity of light emitted from the display device 1.

The optical functional layer OFL may include a light-blocking pattern BM and a color filter CF. The light-blocking pattern BM may be a black matrix. The light-blocking pattern BM may be formed by including an organic light-blocking material or an inorganic light-blocking material including a black pigment and/or dye. The light-blocking pattern BM can at least partially absorb external light or internally reflected light coming from outside the display device 1.

The optical functional layer OFL may have a second opening OP2 formed by a light-blocking pattern BM. A second opening OP2 may be formed corresponding to the first opening OP1. The second opening OP2 may be formed to overlap the first opening OP1. The width W1 of the first opening OP1 and/or the width W2 of the second opening OP2 may be adjusted in consideration of the design of the display device 1, the type (kind) and the resolution of the pixels PX, and/or the like. The width W1 of the first opening OP1 may be different for each pixel PX.

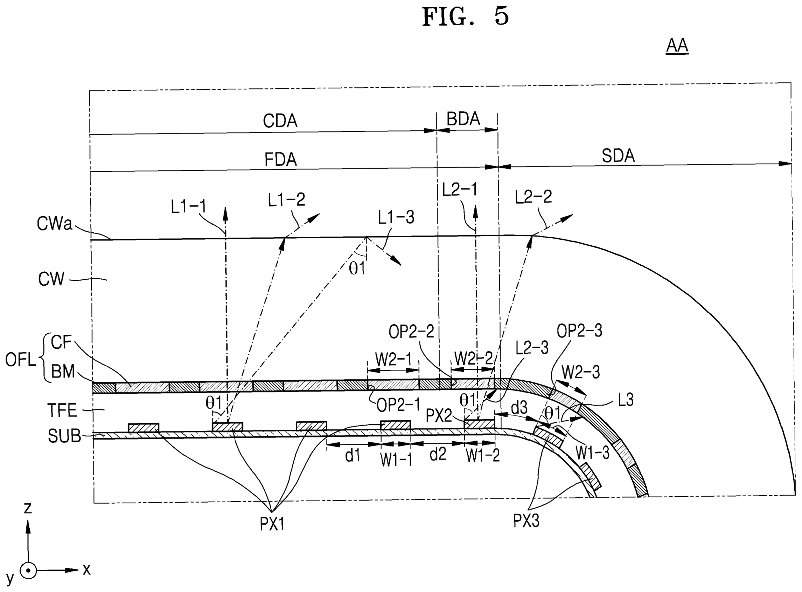

In one or more embodiments, the width W2 of the second opening OP2 may be greater than or equal to the width W1 of the corresponding first opening OP1 among the first openings OP1 defined by the pixel definition layer PDL. In one or more embodiments, the width W2 of the second opening OP2 may vary according to the position of the corresponding first opening OP1, *i.e.,* the position at which the pixel PX is arranged. The variations in the width W2 of the second opening OP2 is described in more detail hereinafter with reference to FIG. 5 and subsequent drawings.

In one or more embodiments, a color filter CF may be positioned in the second opening OP2. A plurality of color filters CFs may be provided to fill a plurality of second openings OP2 formed in an optical functional layer OFL. Color filters CFs may be arranged in consideration of the color of light emitted from each pixel PX of the display panel DP. Each color filter CF may overlap the first opening OP1 to prevent or reduce external light reflection of the display device 1.

The color filter CF may contain red, blue, or green pigments and/or dyes, and may further include quantum dots in addition to the pigments or dyes. In one or more embodiments, the color filter CF may include scattering particles, such as titanium oxide.

In one or more embodiments, the color filters CFs may have a color corresponding to the light emitted by an intermediate layer OL of the organic light-emitting diode OLED positioned thereunder. For example, a red color filter may be positioned on top of a pixel PX that emits red light, a blue color filter may be positioned on top of a pixel PX that emits blue light, and a green color filter may be positioned on top of a pixel PX that emits green light. In such embodiments, if (e.g., when) external light, which is white light, is incident on a red color filter, for example, blue light and green light may be absorbed by the red color filter, and only red light may pass through the red color filter, be reflected by the second electrode EL2, and pass through the red color filter again to be emitted to the outside. Therefore, in the case of a display device 1 having a color filter CF, external light reflection may be reduced to approximately 1/one-third compared to embodiments without the color filter CF.

In one or more embodiments, touch electrode layer including touch electrodes may be positioned between the encapsulation layer TFE and the optical functional layer OFL. The touch electrode layer may obtain coordinate information according to external input, such as a touch event.

A cover window CW may be positioned on the optical functional layer OFL. The cover window CW may be attached to the optical functional layer OFL by an adhesive member. The adhesive may be, for example, a pressure sensitive adhesive (PSA) or an optically clear adhesive (OCA).

The cover window CW may have high transmittance to transmit light emitted from the display panel DP and may have a thin thickness to minimize or reduce the weight of the display device 1. In one or more embodiments, the cover window CW may be configured to have high strength and hardness to protect the display panel DP from external impact. In one or more embodiments, the cover window CW may be a flexible window. The cover window CW may be capable of flexing easily in response to an external force without generating cracks and/or the like, thereby protecting the display panel DP.

For example, the cover window CW may include glass or plastic. As one or more embodiments, the cover window CW may be ultra-thin glass (UTG) whose strength is enhanced by a method such as chemical strengthening or thermal strengthening. In one or more embodiments, the cover window CW may be colorless polyimide (CPI).

FIG. 3 is an equivalent circuit diagram of one pixel included in a display device 1, according to one or more embodiments.

Referring to FIG. 3, a pixel of a display device 1 according to one or more embodiments may include a pixel circuit PC connected to a scan line SL and a data line DL and an organic light-emitting diode OLED connected to the pixel circuit PC. The pixel circuit PC may include a plurality of thin-film transistors (TFTs, *see, e.g.,* FIG. 2) and a storage capacitor Cst. In one or more embodiments, the pixel circuit PC may include a driving thin-film transistor T1, a switching thin-film transistor T2, and a storage capacitor Cst.

The switching thin-film transistor T2 is connected to the scan line SL and the data line DL, and may transmit a data signal or data voltage input from the data line DL to the driving thin-film transistor T1 based on a scan signal or switching voltage input from the scan line SL.

The storage capacitor Cst may be connected to the switching thin-film transistor T2 and the driving voltage line PL, and may be store a voltage corresponding to the difference between the voltage received from the switching thin-film transistor T2 and the first power supply voltage ELVDD supplied to the driving voltage line PL.

The driving thin-film transistor T1 is connected to the driving voltage line PL and the storage capacitor Cst, and may control the driving current flowing through the organic light-emitting diode OLED from the driving voltage line PL in response to the voltage value stored in the storage capacitor Cst.

An organic light-emitting diode OLED may emit light with a preset luminance in response to a driving current supplied through a driving thin-film transistor T1. The counter electrode (e.g., cathode) of the organic light-emitting diode OLED may be supplied with a second power supply voltage ELVSS.

In FIG. 3, embodiments in which the pixel circuit PC includes two thin-film transistors and one storage capacitor is described, but the present disclosure is not limited thereto. The number of thin-film transistors and storage capacitors may vary depending on the design of the pixel circuit PC. For example, a pixel circuit PC may include three, four, five or more thin-film transistors.

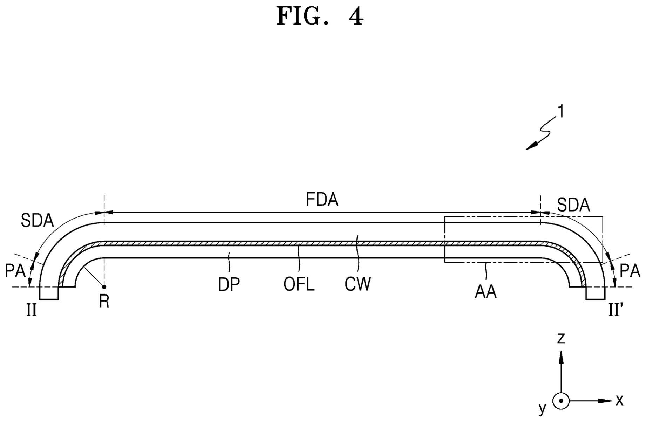

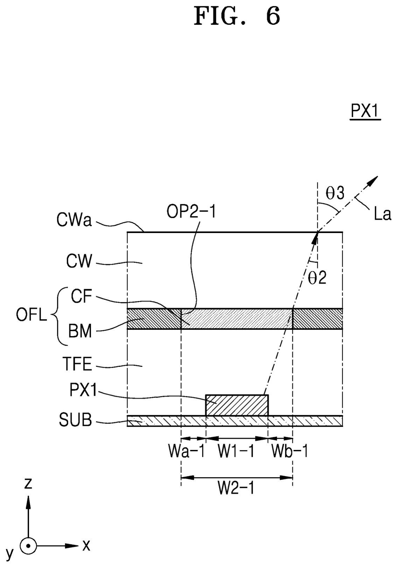

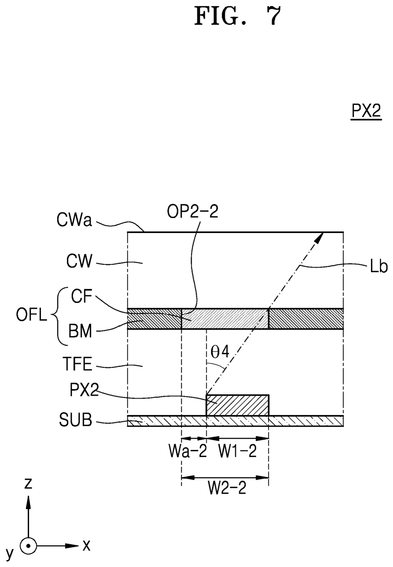

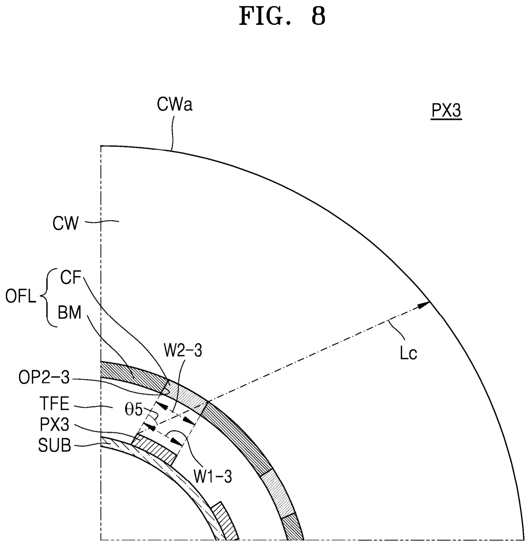

FIG. 4 is a cross-sectional view schematically illustrating a cross section taken along the line II-II' of the display device 1 of FIG. 1, according to one or more embodiments, and FIG. 5 is an enlarged cross-sectional view illustrating the portion AA of FIG. 4, according to one or more embodiments. FIG. 6 is an enlarged view of a first pixel portion of FIG. 5, according to one or more embodiments, FIG. 7 is an enlarged view of a second pixel portion of FIG. 5, according to one or more embodiments, and FIG. 8 is an enlarged view of a third pixel portion of FIG. 5, according to one or more embodiments. In FIGS. 4 to 8, only some components of the display panel DP are shown for convenience of explanation, and the first to the third pixels PX1, PX2, and PX3 may each refer to a light-emitting region of an organic light-emitting diode OLED defined by the first opening OP1 of the pixel definition layer in FIG. 2.

Referring to FIGS. 4 to 8, the display panel DP, the optical functional layer OFL, and the cover window CW may have a shape corresponding to the overall shape of the display device 1. For example, in case that the display device 1 has a rectangular shape on a plane (e.g., in a plan view), the display panel DP, the optical functional layer OFL, and the cover window CW may have a rectangular shape on a plane (e.g., in a plan view).

The display panel DP may include a front display area FDA and a side display area SDA, and the optical functional layer OFL and the cover window CW may include a front portion corresponding to the front display area FDA and a side portion corresponding to the side display area SDA, respectively. In this context, the term 'corresponding' between components may refer to the fact that the components overlap each other when viewed in a direction normal (e.g., perpendicular) to one side of the display panel DP. The side portions of the optical functional layer OFL and the cover window CW may be portions that are bent from their respective front portions.

The front display area FDA of the display panel DP may have a flat surface, and for example, may have a rectangular shape on a plane (e.g., in a plan view). In one or more embodiments, the front display area FDA may be positioned at the center of the display panel DP and may be surrounded by a side display area SDA.

The front display area FDA may include a central display area CDA positioned at the center and a side-adjacent display area BDA positioned at the periphery. The side-adjacent display area BDA may be positioned between the central display area CDA and the side display area SDA. For example, the side-adjacent display area BDA may be defined as the part that forms the border between the front display area FDA and the side display area SDA. At least one first pixel PX1 may be positioned in the central display area CDA, and at least one second pixel PX2 may be positioned in the side-adjacent display area BDA.

In one or more embodiments, the side-adjacent display area BDA has a preset width and may extend along an edge of the front display area FDA. In such embodiments, one or more second pixels PX2 may be arranged in the width direction *(e.g.,* x direction) in the side-adjacent display area BDA.

In one or more embodiments, the side-adjacent display area BDA may be defined based on the positions of pixels positioned above the substrate SUB. For example, the second pixel PX2 may be defined as the outermost pixels positioned adjacent to the side display area SDA among the pixels positioned in the front display area FDA, and the side-adjacent display area BDA may be defined as the area in which the second pixel PX2 is arranged. A plurality of second pixels PX2 may be positioned along the boundary between the front display area FDA and the side display area SDA, and in such embodiments, the side-adjacent display area BDA may be defined along (e.g., based on) the arrangement of the second pixels PX2.

The side display area SDA of the display panel DP may extend from the front display area FDA and may be bent. For example, the front display area FDA may have a rectangular shape includes four edge lines, and the side display area SDA may extend outward from each edge line of the front display area FDA and may be bent. In one or more embodiments, the side display area SDA may be bent about an imaginary bending axis R that is parallel to the edge line of the front display area FDA, and may have a preset curvature The bending axis R is positioned on the inner side of the display panel DP, where the 'inner side' of the display panel DP may refer to the opposite side to the side to which the cover window CW is attached. At least one third pixel PX3 may be positioned in the side display area SDA.

In one or more embodiments, pixels positioned on the display panel DP may be sequentially arranged as a first pixel PX1, a second pixel PX2, and a third pixel PX3 from the center toward the edge having a curved surface. The first pixel PX1, the second pixel PX2, and the third pixel PX3 may be positioned at regular intervals. For example, in the central display area CDA, a first distance d1 at which the first pixels PX1 are spaced and/or apart (e.g., spaced apart or separated) from each other, a second distance d2 at which the first pixel PX1 and the second pixel PX2 are spaced and/or apart (e.g., spaced apart or separated) from each other, and a third distance d3 at which the second pixel PX2 and the third pixel PX3 are spaced and/or apart (e.g., spaced apart or separated) from each other may be equal to each other.

In one or more embodiments, the width W1-1 of the first pixel PX1, the width W1-2 of the second pixel PX2, and the width W1-3 of the third pixel PX3 may be equal. The width of the first to the third pixels PX1, PX2, and PX3 may be defined as the length of the first to the third pixels PX1, PX2, and PX3 extending along the direction in which the first to the third pixels PX1, PX2, and PX3 are positioned in a cross section (e.g., a cross-section along the x or y direction), and may correspond to the width W1 of the first opening OP1 formed in the pixel definition layer (PDL, *see, e.g.,* FIG. 2). However, the present disclosure is not limited thereto, and the width W1-1 of the first pixel PX1, the width W1-2 of the second pixel PX2, and the width W1-3 of the third pixel PX3 may be different from each other. Hereinafter, for convenience of explanation, the present disclosure will be described with reference to embodiments in which the width W1-1 of the first pixel PX1, the width W1-2 of the second pixel PX2, and the width W1-3 of the third pixel PX3 are the same. It will be understood that the pixel definition layer PDL may include a first-1 opening OP1-1 overlapping the first pixel PX1, a first-2 opening OP1-2 overlapping the second pixel PX2, and a first-3 opening OP1-3 overlapping the third pixel PX3.

An optical functional layer OFL including a light-blocking pattern BM and a color filter CF may be arranged on the upper part of the display panel DP. The optical functional layer OFL may be spaced and/or apart (e.g., spaced apart or separated) from the pixels PX1, PX2, and PX3 of the display panel DP by a preset interval in a thickness direction. The optical functional layer OFL may include a second-1 opening OP2-1 overlapping the first pixel PX1, a second-2 opening OP2-2 overlapping the second pixel PX2, and a second-3 opening OP2-3 overlapping the third pixel PX3.

In one or more embodiments, a color filter CF may be positioned in each of the second-1 opening OP2-1, the second-2 opening OP2-2, and the second-3 opening OP2-3. In one or more embodiments, the widths of the second-1 opening OP2-1, the second-2 opening OP2-2, and the second-3 opening OP2-3 may differ. For example, the first pixel PX1, the second pixel PX2, and the third pixel PX3 may have different width ratios relative to the corresponding second opening OP2.

Light emitted from the emission surface of the first pixel PX1 may be emitted at various angles with respect to the emission surface of the first pixel PX1. In one or more embodiments, the first pixel PX1 may emit light that travels along a first-1 path L1-1 that is substantially normal (e.g., perpendicular) to the emission surface. Light traveling along the first-1 path L1-1 may pass through the second-1 opening OP2-1 and the cover window CW, thereby being visible to a user in a front direction. In this regard, the frontward direction may refer to a direction in which the display device 1 is viewed along the negative z-axis (-z direction).

In one or more embodiments, the first pixel PX1 may emit light that travels along the first-2 path L1-2 while forming a relatively small angle with the emission surface. Light traveling along the first-2 path L1-2 passes through the second-1 opening OP2-1 and enters the cover window CW, and is then refracted at a surface CWa of the cover window CW before being emitted, thereby allowing visibility to the user from the front direction.

As illustrated in FIG. 6, the width W2-1 of the second-1 opening OP2-1 may be designed so that light emitted from one edge of the emission surface of the first pixel PX1 and traveling along the first-4 path La is not blocked by the light-blocking pattern BM, and is emitted from a surface CWa of the cover window CW at a preset emission angle (θ3, *e.g.,* 45°).

In one or more embodiments, the width W2-1 of the second-1 opening OP2-1 may be greater than the width W1-1 of the first pixel PX1. For example, the second-1 opening OP2-1 may be expanded by a first distance Wa-1 in the -x direction and by a second distance Wb-1 in the x direction compared to the first pixel PX1. The first distance Wa-1 and the second distance Wb-1 may be equal. In this way, the display device 1 may increase the light emission efficiency of the first pixel PX1 by making the width W2-1 of the second-1 opening OP2-1 larger than the width W1-1 of the corresponding first pixel PX1.

In one or more embodiments, as illustrated in FIG. 5, light emitted from the emission surface of the first pixel PX1 at an emission angle of the first angle θ1 may travel along the first-3 path L1-3, pass through the second-1 opening OP2-1, and be incident on the cover window CW, after which it may be totally reflected at one surface CWa of the cover window CW and returned to the display panel DP side. For example, light emitted from the first pixel PX1 at an emission angle of the first angle θ1 may not be emitted to the outside of the display device 1.

In the second pixel PX2, as in the first pixel PX1, light traveling along the second-1 path L2-1, which is substantially normal (e.g., perpendicular) to the emission surface of the second pixel PX2, and light traveling along the second-2 path L2-2, which forms a relatively small angle with respect to the emission surface of the second pixel PX2, may pass through the second-2 opening OP2-2 and the cover window CW, and thereby be visible to the user from the front direction.

Light emitted from the emission surface of the second pixel PX2 toward the side display area SDA at an emission angle of the first angle θ1 may travel along the second-3 path L2-3 and may be blocked by the light-blocking pattern BM. In this regard, the first angle θ1 may be an emission angle corresponding to a light path that is totally reflected in the first pixel PX1, and hereinafter, light emitted at an emission angle of the first angle θ1 may be referred to as totally reflected light.

In the case where the light to be totally reflected is emitted from the second pixel PX2 toward the side display area SDA and is not blocked by the light-blocking pattern BM, the light to be totally reflected may be incident on the cover window CW of the adjacent side display area SDA and may be emitted to the outside without being totally reflected by one surface CWa of the cover window CW, thereby becoming visible to the user. In such cases, in a flat cover window CW, the light that would otherwise be trapped inside the display device 1 by being totally reflected is emitted to the outside due to the curvature of the cover window CW, resulting in color mixing with the light of the adjacent third pixel PX3, causing a display defect.

Accordingly, the display device 1 according to one or more embodiments can prevent or reduce the likelihood of light emitted toward the side display area SDA from being emitted to the outside by changing the width of the second-2 opening OP2-2 through which light emitted from the second pixel PX2 passes to have a different width from the 2-1 opening OP2-1. In one or more embodiments, the width W2-2 of the second-2 opening OP2-2 corresponding to the second pixel PX2 may have a smaller size than the width W2-1 of the second-1 opening OP2-1.

For example, as illustrated in FIG. 7, the width W2-2 of the second-2 opening OP2-2 may have a size that is expanded only on one side compared to the width W1-2 of the second pixel PX2. By making the width W2-2 of the second-2 opening OP2-2 expand on one side compared to the width W1-2 of the second pixel PX2, the light emitted from one end of the second pixel PX2 toward the side display area SDA may be blocked, while the light emitted from the other end of the second pixel PX2 toward the front display area FDA may not be blocked. In this instance, one end and the other end of the second pixel PX2 may refer to the ends in the -x direction and the x direction, respectively.

In one or more embodiments, the width W2-2 of the second-2 opening OP2-2 may be expanded by a third distance Wa-2 in the -x direction with respect to one end of the second pixel PX2 and may be aligned within a preset tolerance range with respect to the other end of the second pixel PX2. In one or more embodiments, the third distance Wa-2 may be equal to the first distance Wa-1, which is the amount by which the second-1 opening OP2-1 is expanded in the -x direction from the first pixel PX1, but the present disclosure is not limited thereto.

In one or more embodiments, as illustrated in FIG. 7, light of the second-4 path Lb emitted from one end of the second pixel PX2 toward the side display area SDA at an emission angle of the fourth angle θ4, may pass through the second-2 opening OP2-2 and be emitted to the outside. The fourth angle θ4 may have a smaller value than the first angle θ1.

Referring again to FIG. 5, the width W2-3 of the second-3 opening OP2-3 formed on the 3rd pixel PX3 may have a different size from the width W2-1 of the second-1 opening OP2-1 or the width W2-2 of the second-2 opening OP2-2. The second-3 opening OP2-3 formed in the optical functional layer OFL has an emission angle of the first angle θ1 and may be formed with a size that blocks light traveling along the third-1 path L3.

The second-3 opening OP2-3 may be formed with a size that minimizes the emission of the total reflection light to the outside without reducing the light emission efficiency of light emitted from the third pixel PX3. In one or more embodiments, the width W2-3 of the second-3 opening OP2-3 corresponding to the third pixel PX3 may have a smaller size than the width W2-1 of the second-1 opening OP2-1 or the width W2-2 of the second-2 opening OP2-2.

For example, as illustrated in FIG. 8, the width W2-3 of the second-3 opening OP2-3 may have a size corresponding to the width W1-3 of the third pixel PX3. The width W2-3 of the second-3 opening OP2-3 may be equal to the width W1-3 of the third pixel PX3 within a tolerance range, and the edge of the second-3 opening OP2-3 may overlap the edge of the third pixel PX3 if *(e.g.,* when) viewed in a direction normal *(e.g.,* perpendicular) to one side of the third pixel PX3.

Accordingly, light of the third-2 path Lc emitted at an emission angle of the fifth angle θ5 from the emission surface of the third pixel PX3 may pass through the second-3 opening OP2-3 and be emitted to the outside, and at this time, the fifth angle θ5 may have a smaller value than the first angle θ1.

In one or more embodiments, the luminance of light emitted from the first pixel PX1, the second pixel PX2, and the third pixel PX3 may be the same or different from each other. In one or more embodiments, the display device 1 may individually control the pixel circuits *(e.g.,* pixel circuits PC, *see, e.g.,* FIG. 3) of the first pixel PX1, the second pixel PX2, and the third pixel PX3 to change the luminance of light emitted from the first pixel PX1, the second pixel PX2, and the third pixel PX3. For example, the display device 1 may improve the uniformity of light emitted to the outside of the display device 1 by controlling the luminance of light emitted from the third pixel PX3 to be higher than that of the first pixel PX1 and the second pixel PX2, or by controlling the luminance of light emitted from the second pixel PX2 to be higher than that of the first pixel PX1.

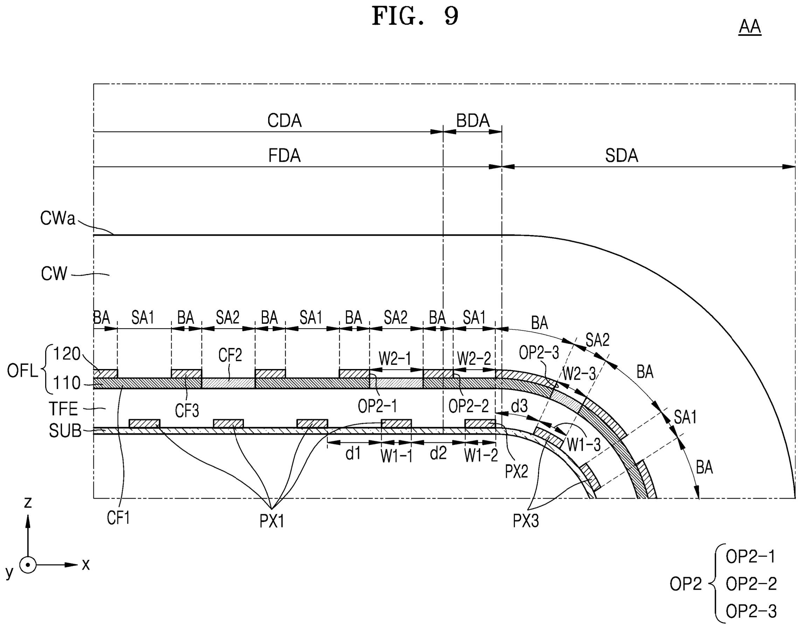

FIG. 9 is a cross-sectional view illustrating a display device according to one or more embodiments. FIG. 9 is an enlarged cross-sectional view of the portion AA of FIG. 4, according to one or more embodiments. In comparison with the display device according to the embodiments described in FIG. 5, the display device according to the embodiments illustrated in FIG. 9 differ in the structure of the optical functional layer OFL. Accordingly, a description will focus on the aforementioned difference.

Referring to FIG. 9, the optical functional layer OFL may include a plurality of color filter layers. In one or more embodiments, the optical functional layer OFL may include a first color filter layer 110 and a second color filter layer 120. The optical functional layer OFL may be positioned on the upper part of the display panel DP and may block or transmit light emitted from each pixel of the display panel DP. In one or more embodiments, light passing through the optical functional layer OFL may undergo color conversion.

The first color filter layer 110 may have a structure in which the first color filter CF1 and the second color filter CF2 are arranged in an alternating manner. In one or more embodiments, the first color filter CF1 may form a base of the first color filter layer 110, and an opening may be formed in the first color filter CF1 in which the second color filter CF2 is arranged.

The second color filter layer 120 may include a third color filter CF3. The third color filter CF3 may be positioned in the blocking area BA and overlap the first color filter CF1 to block or reduce the movement of light. For example, one of the first color filter CF1 and the third color filter CF3 may be a blue color filter, and the other may be a red color filter, and as the blue color filter and the red color filter overlap, most of the visible light may be absorbed by the blue color filter and the red color filter, thereby blocking or reducing the movement of light.

In the second color filter layer 120, second openings OP2 may be formed by the third color filter CF3. The region where the first color filter CF1 is exposed by the second opening OP2 may be defined as a first sub-area SA1, and the region where the second color filter CF2 is exposed by the second opening OP2 may be defined as a second sub-area SA2. The first sub-area SA1 and the second sub-area SA2 may be alternately arranged in the first direction, and a blocking area BA may be positioned between each of the first sub-area SA1 and the second sub-area SA2.

The second opening OP2 formed in the second color filter layer 120 may overlap pixels PX1, PX2, and PX3 of the display panel DP. The second opening OP2 may include a second-1 opening OP2-1 overlapping the first pixel PX1, a second-2 opening OP2-2 overlapping the second pixel PX2, and a second-3 opening OP2-3 overlapping the third pixel PX3.

In one or more embodiments, the width W2-1 of the second-1 opening OP2-1, the width W2-2 of the second-2 opening OP2-2, and the width W2-3 of the second-3 opening OP2-3 may be different from each other. For example, the width W2-2 of the second-2 opening OP2-2 may be smaller than the width W2-1 of the second-1 opening OP2-1, and the width W2-3 of the second-3 opening OP2-3 may be smaller than the width W2-2 of the second-2 opening OP2-2.

In one or more embodiments, the second-1 opening OP2-1 may have a width W2-1 greater than a width W1-1 of the first pixel PX1, and the first pixel PX1 may be positioned to overlap a central portion of the second-1 opening OP2-1. The width W2-1 of the second-1 opening OP2-1 may be designed such that the maximum emission angle of light emitted from one edge of the first pixel PX1 toward one side of the second-1 opening OP2-1 corresponding to the one edge has a preset value.

The second-2 opening OP2-2 may have a width W2-2 greater than the width W1-2 of the second pixel PX2, and the second-1 opening OP2-1 may have a width smaller than the width W2-1, and one edge of the second pixel PX2 may be positioned to overlap one edge of the second-2 opening OP2-2. The width W2-2 of the second-2 opening OP2-2 may be designed to block or reduce the light emitted from the second pixel PX2 to the side display area SDA (e.g., the totally reflected light).

The second-3 opening OP2-3 may have a width W2-3 that is equal to the width W1-3 of the third pixel PX3, and may be positioned so that the entire third pixel PX3 overlaps the second-3 opening OP2-3. The width W2-3 of the second-3 opening OP2-3 may be designed so that the light intended to be totally reflected is prevented from being emitted to the outside as much as possible without reducing the light emission efficiency of light emitted from the third pixel PX3.

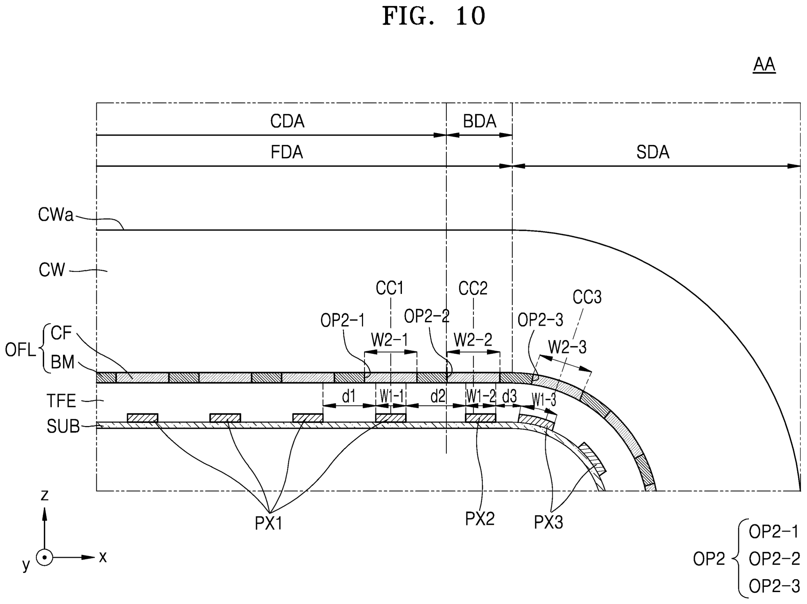

FIG. 10 is a cross-sectional view illustrating a display device according to one or more embodiments. FIG. 10 is an enlarged cross-sectional view of the portion AA of FIG. 4, according to one or more embodiments. In comparison with the display device according to the embodiments described in FIG. 5, the display device according to the embodiments illustrated in FIG. 10 differ in the structure of the second opening OP2 formed in the optical functional layer OFL and in the arrangement of the pixels PX1, PX2, and PX3. Accordingly, the following description will focus on these differences.

Referring to FIG. 10, the optical functional layer OFL may include a plurality of second openings OP2 arranged at regular intervals. The second opening OP2 may include a second-1 opening OP2-1 overlapping the first pixel PX1, a second-2 opening OP2-2 overlapping the second pixel PX2, and a second-3 opening OP2-3 overlapping the third pixel PX3, and the second-1 opening OP2-1, the second-2 opening OP2-2, and the second-3 opening OP2-3 may all have the same area.

For example, the width W2-1 of the second-1 opening OP2-1, the width W2-2 of the second-2 opening OP2-2, and the width W2-3 of the second-3 opening OP2-3 may all be equal. In one or more embodiments, the width W2-1 of the second-1 opening OP2-1, the width W2-2 of the second-2 opening OP2-2, and the width W2-3 of the second-3 opening OP2-3 may have values greater than the widths of the corresponding pixels.

In one or more embodiments, the first pixel PX1, the second pixel PX2, and the third pixel PX3 may be aligned in different directions with respect to the corresponding second opening OP2. For example, the first pixel PX1 may be positioned such that the center of the first pixel PX1 is aligned with a first center line CC1 passing through the center of the second-1 opening OP2-1. Accordingly, a portion of the light emitted from the first pixel PX1 may pass through the second-1 opening OP2-1, which is formed to be larger than the first pixel PX1 and may be incident on the cover window CW, and the light incident on the cover window CW may be emitted to the outside, except for the light that undergoes total reflection on one surface CWa of the cover window CW.

The second pixel PX2 may be positioned such that the center of the second pixel PX2 is offset in a preset direction with respect to the second center line CC2 passing through the center of the second-2 opening OP2-2. In this instance, the preset direction in which the center of the second pixel PX2 moves may refer to the direction toward the side display area SDA (e.g., the x direction). Accordingly, the light emitted from the second pixel PX2 toward the side display area SDA (e.g., the totally reflected light) may be blocked by the light-blocking pattern BM of the optical functional layer OFL.

The third pixel PX3 may be positioned such that the center of the third pixel PX3 is offset in a preset direction with respect to the third center line CC3 passing through the center of the second-3 opening OP2-3. In this instance, the direction in which the center of the third pixel PX3 moves may refer to the direction toward the front display area FDA (e.g., the -x direction). Accordingly, the light emitted from the third pixel PX3 toward the front display area FDA (e.g., the totally reflected light) may be blocked by the light-blocking pattern BM of the optical functional layer OFL.

As described above, the display device 1 according to one or more embodiments may be configured such that the widths of the second-1 opening OP2-1, the second-2 opening OP2-2, and the second-3 opening OP2-3, which are formed in the optical functional layer OFL, are different from each other or the arrangements and/or positions of the pixels corresponding to the second-1 opening OP2-1, the second-2 opening OP2-2, and the second-3 opening OP2-3 are different from each other, thereby making the emission angle ranges of the light emitted from the first pixel PX1 arranged in the central display area CDA, the second pixel PX2 arranged in the side-adjacent display area BDA, and the third pixel PX3 arranged in the side display area SDA different from each other, and preventing or reducing the likelihood of the light of the first pixel PX1, the second pixel PX2, and the third pixel PX3 color mixing on the side of the display device 1.

The display device 1 according to one or more embodiments may be applied to various, suitable electronic devices. An electronic device according to one or more embodiments may include the display device 1 described above, and may further include a module or a device having additional functions in addition to the display device 1.

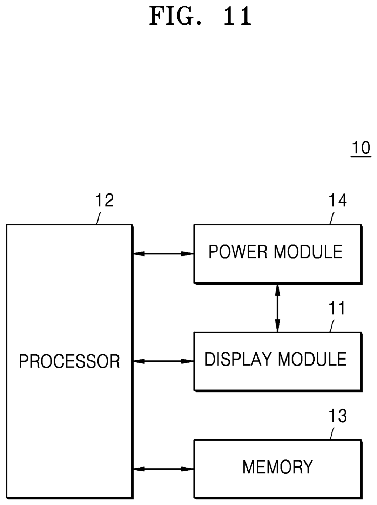

FIG. 11 is a block diagram of an electronic device 10 according to one or more embodiments.

Referring to FIG. 11, an electronic device 10 according to one or more embodiments may include a display module 11, a processor 12, a memory 13, and a power module 14.

The processor 12 may include at least one of a central processing unit (CPU), an application processor (AP), a graphic processing unit (GPU), a communication processor (CP), an image signal processor (ISP), and/or a controller.

Data information for the operation of the processor 12 or the display module 11 may be stored in the memory 13. When the processor 12 executes an application stored in the memory 13, an image data signal and/or an input control signal is transmitted to the display module 11, and the display module 11 may process the received signal and output image information through a display screen.

The power module 14 may include a power supply module, such as a power adapter or a battery device, and a power conversion module that converts power supplied by the power supply module to generate power for the operation of the electronic device 10.

At least one of the components of the electronic device 10 may be included in the display device according to one or more embodiments. In one or more embodiments, some of the individual modules functionally included within a single module may be included within the display device, while others may be provided separately from the display device. For example, the display device may include a display module 11, and a processor 12, a memory 13 and a power module 14 may be provided in the form of other devices within the electronic device 10, other than the display device.

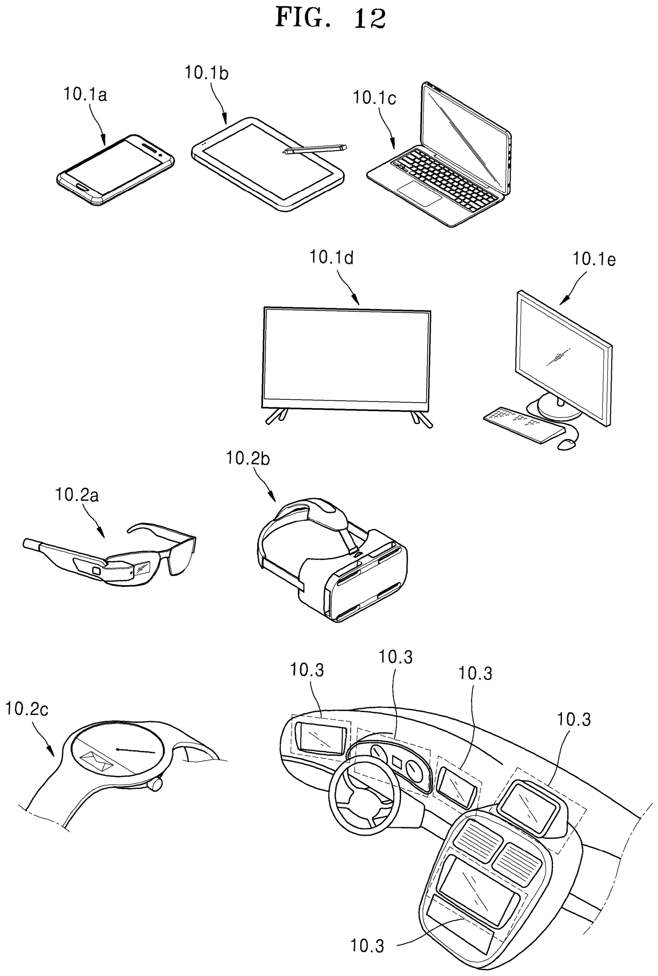

FIG. 12 is a schematic diagram of electronic devices according to various embodiments.

Referring to FIG. 12, one or more suitable electronic devices to which the display device according to one or more embodiments may be applied may include not only image display electronic devices such as a smartphone 10.1a, a tablet PC 10.1b, a laptop 10.1c, a TV 10.1d, and/or a desk monitor 10.1e, but also wearable electronic devices including display modules such as smart glasses 10.2a, a head-mounted display 10.2b, and/or a smart watch 10.2c. In one or more embodiments, the display device may be applied to vehicle electronic devices 10.3 including a display module, such as a center information display (CID) positioned on an instrument cluster, a center fascia, or a dashboard of a vehicle, and/or a room mirror display.

The display device and the electronic device according to one or more embodiments may improve display quality by preventing or reducing the likelihood of light emitted from a front display area at an angle greater than a preset angle from being emitted to a side display area, thus reducing the likelihood of color mixing with light emitted from adjacent pixels, and by reducing the difference in light characteristics between the front display area and the side display area.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

Further, the use of "may" when describing embodiments refers to "one or more embodiments."

As used herein, the term "substantially," "about," and similar terms are used as terms of approximation and not as terms of degree, and are intended to account for the inherent deviations in measured or calculated values that would be recognized by those of ordinary skill in the art. "Substantially" as used herein, is inclusive of the stated value and means within an acceptable range of deviation for the particular value as determined by one of ordinary skill in the art, considering the measurement in question and the error associated with measurement of the particular quantity *(i.e.,* the limitations of the measurement system). For example, "substantially" may mean within one or more standard deviations, or within ± 30%, 20%, 10%, 5% of the stated value. Also, it should be understood that, even if the terms "about," "approximately," or "substantially" are not expressly recited in a given element (e.g., a claim element), the scope of such element is intended to include variations that are insubstantial or within the understanding of one of ordinary skill in the art. For example, numerical values and ranges provided herein are intended to include tolerances and measurement uncertainties that would be recognized by those skilled in the art, and the elements (e.g., claim elements) should be construed accordingly to encompass such equivalents.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

The display device, electronic device, device for manufacturing the display device, and/or any other relevant devices or components according to embodiments described herein may be implemented utilizing any suitable hardware, firmware (e.g., an application-specific integrated circuit), software, or a combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the present disclosure.

A person of ordinary skill in the art, in view of the present disclosure in its entirety, would appreciate that each suitable feature of the various embodiments may be combined or combined with each other, partially or entirely, and may be technically interlocked and operated in various suitable ways, and each embodiment may be implemented independently of each other or in conjunction with each other in any suitable manner unless otherwise stated or implied.

It will be understood that descriptions of features or aspects within each embodiment should typically be considered as available for other similar features or aspects in other embodiments, unless otherwise described. Thus, as would be apparent to one of ordinary skill in the art, features, characteristics, and/or elements described in connection with a particular embodiment may be used singly or in combination with features, characteristics, and/or elements described in connection with other embodiments unless otherwise specifically indicated. It is to be understood that the foregoing is an illustration of various example embodiments and is not to be construed as limited to the specific embodiments disclosed herein, and that various modifications to the disclosed embodiments, as well as other example embodiments, are intended to be included within the scope of the invention as defined in the appended claims.

## Claims

1. A display device comprising:
a substrate comprising a front display area (FDA) and a side display area (SDA) connected to the front display area (FDA) in a first direction and having a preset curvature;
a pixel definition layer (PDL) on the substrate; and
an optical functional layer (OFL) on the pixel definition layer, wherein
the front display area (FDA) comprises a central display area (CDA) and a side-adjacent display area (BDA) between the central display area (CDA) and the side display area (SDA),
the pixel definition layer (PDL) comprises a first-1 opening (OP1-1) overlapping the central display area (CDA), a first-2 opening (OP1-2) overlapping the side-adjacent display area (BDA), and a first-3 opening (OP1-3) overlapping the side display area (SDA),
the optical functional layer (OFL) comprises a second-1 opening (OP2-1) overlapping the first-1 opening (OP1-1), a second-2 opening (OP2-2) overlapping the first-2 opening (OP1-2), and a second-3 opening (OP2-3) overlapping the first-3 opening (OP1-3), and
the first-2 opening (OP1-2) is offset in the first direction relative to one side of the second-2 opening (OP2-2).

2. The display device of claim 1, wherein a width of the second-1 opening, a width of the second-2 opening, and a width of the second-3 opening are different from each other.

3. The display device of claim 2, wherein a width of the first-1 opening, a width of the first-2 opening, and a width of the first-3 opening are the same.

4. The display device of claim 1, wherein a width of the second-2 opening is greater than a width of the first-2 opening, and a width of the second-3 opening is equal to a width of the first-3 opening.

5. The display device of claim 1, wherein a width of the second-2 opening is less than a width of the second-1 opening and greater than a width of the second-3 opening.

6. A display device comprising:
a substrate comprising a front display area (FDA) and a side display area (SDA) connected to the front display area (FDA) in a first direction and having a preset curvature;
a pixel definition layer (PDL) on the substrate; and
an optical functional layer (OFL) on the pixel definition layer,
wherein the front display area (FDA) comprises a central display area (CDA) and a side-adjacent display area (BDA) between the central display area (CDA) and the side display area (SDA),
the pixel definition layer (PDL) comprises a first-1 opening (OP1-1) overlapping the central display area, a first-2 opening (OP1-2) overlapping the side-adjacent display area, and a first-3 opening (OP1-3) overlapping the side display area,
the optical functional layer (OFL) comprises a second-1 opening (OP2-1) overlapping the first-1 opening (OP1-1), a second-2 opening (OP2-2) overlapping the first-2 opening (OP1-2), and a second-3 opening (OP2-3) overlapping the first-3 opening (OP1-3), and
the ratio of a width (W1-1) of the first-1 opening (OP1-1) to a width (W2-1) of the second-1 opening (OP2-1), the ratio of a width (W1-2) of the first-2 opening (OP1-2) to a width (W2-2) of the second-2 opening (OP2-2), and the ratio of a width (W1-3) of the first-3 opening (OP1-3) to a width (W2-3) of the second-3 opening (OP2-3) are different from each other.

7. The display device of claim 6, wherein the widths of the first-1 opening, the first-2 opening, and the first-3 opening are the same, and the widths of the second-1 opening, the second-2 opening, and the second-3 opening are different from each other.

8. The display device of claim 7, wherein a width of the second-2 opening is smaller than a width of the second-1 opening and greater than a width of the second-3 opening.

9. The display device of claim 6, wherein the width of the second-2 opening is greater than the width of the first-2 opening, and the width of the second-3 opening is equal to the width of the first-3 opening.

10. The display device of claim 6, wherein the first-2 opening is offset in the first direction relative to one side of the second-2 opening.

11. The display device of claim 1 or 6, wherein a center of the first-1 opening coincides with a center of the second-1 opening, and a center of the first-3 opening coincides with a center of the second-3 opening.

12. The display device of claim 1 or 6, wherein the distance between one end of the first-1 opening and one end of the second-1 opening is equal to the distance between one end of the first-2 opening and one end of the second-2 opening.

13. The display device of claim 1 or 6, wherein the first-3 opening is offset in the first direction relative to one side of the second-3 opening.

14. The display device of claim 1 or 6, wherein a separation distance between the first-1 opening and the first-2 opening is equal to or greater than a separation distance between the first-2 opening and the first-3 opening.

15. An electronic device comprising:
a processor configured to generate a scan input signal;
a power module configured to generate a scan input voltage; and
a display device according to any one of the preceding claims configured to receive the scan input signal and the scan input voltage and to output a scan signal to a pixel circuit.
